# EUROPEAN PATENT APPLICATION

(11) **EP 4 358 324 A1**
(43) Date of publication of application: **24.04.2024**
(21) Application number: 22824944.7
(22) Date of filing: 13.06.2022
(51) Int. Cl.: H01S 5/183, H01S 5/42

(54) **SEMICONDUCTOR DEVICE, METHOD AND APPARATUS FOR PRODUCING SEMICONDUCTOR DEVICE, AND ELECTRONIC INSTRUMENT**

(30) Priority: 16.06.2021 JP 2021100395
(71) Applicant: Kyocera Corporation, Kyoto-shi Kyoto 612-8501 (JP)
(72) Inventor: KAMIKAWA, Takeshi, Kyoto-shi, Kyoto 612-8501 (JP); KAWAGUCHI, Yoshinobu, Kyoto-shi, Kyoto 612-8501 (JP); TANIGUCHI, Yuki, Kyoto-shi, Kyoto 612-8501 (JP); MURAKAWA, Kentaro, Kyoto-shi, Kyoto 612-8501 (JP)
(74) Representative: Viering, Jentschura & Partner mbB Patent- und Rechtsanwälte
(86) International application number: PCT/JP2022/023567
(87) International publication number: WO 2022/264954

(57) **Abstract**

A semiconductor device includes a semiconductor substrate including a main substrate, a base semiconductor part located above the main substrate, and a hole penetrating the main substrate in a thickness direction, a compound semiconductor part located above the base semiconductor part, a first light reflector located above the compound semiconductor part, and a second light reflector disposed in the hole, overlapping the first light reflector, and below the first light reflector.

## Description

### TECHNICAL FIELD

The present disclosure relates to a semiconductor device and the like.

### BACKGROUND OF INVENTION

Patent Document 1 discloses a surface emitting semiconductor laser element in which a distributed Bragg reflector (DBR) layer and a light-emitting layer are provided on a GaN substrate. The structure in which the DBR is provided on the GaN substrate has heat dissipation problems.

### CITATION LIST

### PATENT LITERATURE

Patent Document 1: JP 6555260 B

### SUMMARY

A semiconductor device according to the present disclosure includes a semiconductor substrate including a main substrate, a base semiconductor part located above the main substrate, and a hole penetrating the main substrate in a thickness direction, a compound semiconductor part located above the base semiconductor part,
a first light reflector located above the compound semiconductor part, and
a second light reflector disposed in the hole, overlapping the first light reflector, and below the first light reflector.

### BRIEF DESCRIPTION OF THE DRAWINGS

FIG. 1 is a cross-sectional view illustrating the configuration of a semiconductor device according to the present embodiment.
FIG. 2 is a flowchart illustrating an example of a method for manufacturing a semiconductor device according to the present embodiment.
FIG. 3 is a block diagram illustrating an example of an apparatus for manufacturing the semiconductor device according to the present embodiment.
FIG. 4 is a cross-sectional view illustrating a configuration of a semiconductor device according to the present embodiment.
FIG. 5 is a cross-sectional view illustrating a configuration of the semiconductor device according to Example 1.
FIG. 6 is another cross-sectional view illustrating another configuration of the semiconductor device according to Example 1.
FIG. 7 is a plan view illustrating the configuration of the semiconductor device according to Example 1.
FIG. 8 is a partial enlarged cross-sectional view illustrating the configuration of the semiconductor device according to Example 1.
FIG. 9 is a flowchart illustrating an example of a method for manufacturing the semiconductor device according to Example 1.
FIG. 10 illustrates cross-sectional views of steps of an example of the method for manufacturing the semiconductor device according to Example 1.
FIG. 11 illustrates cross-sectional views of an example of lateral growth of a base semiconductor part.
FIG. 12 is a cross-sectional view illustrating the configuration of the semiconductor device according to Example 1.
FIG. 13 is a plan view illustrating another configuration of the semiconductor device according to Example 1.
FIG. 14 is a cross-sectional view illustrating another configuration of the semiconductor device according to Example 1.
FIG. 15 is a cross-sectional view illustrating another configuration of the semiconductor device according to Example 1.
FIG. 16 is a cross-sectional view illustrating another configuration of the semiconductor device according to Example 1.
FIG. 17 is a cross-sectional view illustrating another configuration of the semiconductor device according to Example 1.
FIG. 18 is a cross-sectional view illustrating another configuration of the semiconductor device according to Example 1.
FIG. 19 is a cross-sectional view illustrating another configuration of the semiconductor device according to Example 1.
FIG. 20 is a cross-sectional view illustrating another configuration of the semiconductor device according to Example 1.
FIG. 21 is a cross-sectional view illustrating another configuration of the semiconductor device according to Example 1.
FIG. 22 is a cross-sectional view illustrating another configuration of the semiconductor device according to Example 1.
FIG. 23 is a cross-sectional view illustrating another configuration of the semiconductor device according to Example 1.
FIG. 24 is a cross-sectional view illustrating another configuration of the semiconductor device according to Example 1.
FIG. 25 is a cross-sectional view illustrating another configuration of the semiconductor device according to Example 1.
FIG. 26 is a cross-sectional view illustrating another configuration of the semiconductor device according to Example 1.
FIG. 27 is a cross-sectional view of a semiconductor device along an X-direction according to Example 2.
FIG. 28 is a cross-sectional view of the semiconductor device along a Y-direction according to Example 2.
FIG. 29 is a flowchart illustrating an example of a method for manufacturing the semiconductor device illustrated in FIG. 27.
FIG. 30 is a cross-sectional view illustrating another configuration of the semiconductor device according to Example 2.
FIG. 31 is a flowchart illustrating an example of a method for manufacturing the semiconductor device illustrated in FIG. 30.
FIG. 32 illustrates cross-sectional views of steps of an example of the method for manufacturing the semiconductor device illustrated in FIG. 30.
FIG. 33 is a schematic diagram illustrating a configuration of an electronic device according to Example 4.

### DESCRIPTION OF EMBODIMENTS

### Semiconductor Device

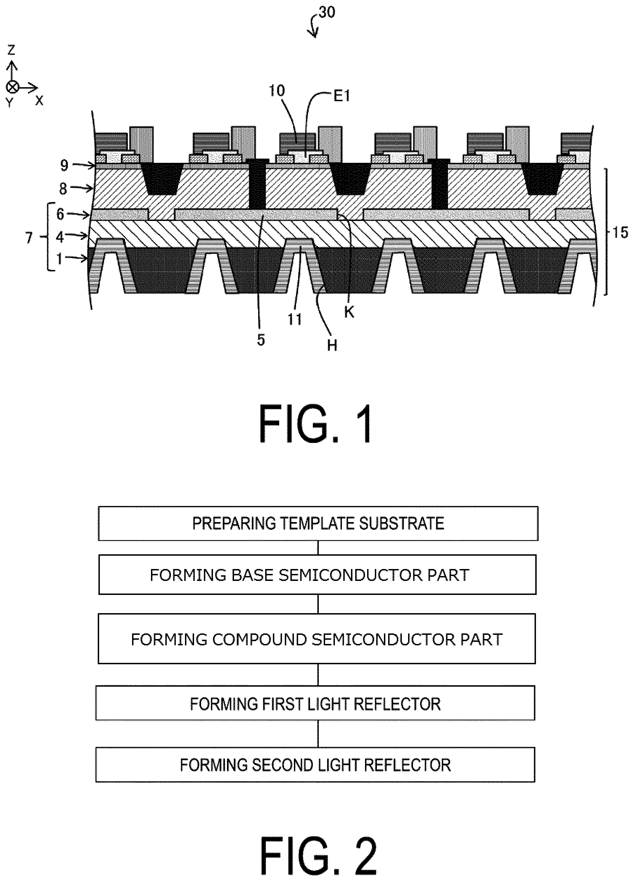

FIG. 1 is a cross-sectional view illustrating a configuration of a semiconductor device according to the present embodiment. As illustrated in FIG. 1, a semiconductor device 30 according to the present embodiment includes (i) a semiconductor substrate 15 including a main substrate 1, a mask pattern 6 located above the main substrate 1, a base semiconductor part 8 located above the mask pattern 6, and a hole H penetrating the main substrate 1, (ii) a compound semiconductor part 9 located above the base semiconductor part 8, (iii) a first light reflector 10 located above the compound semiconductor part 9, and (iv) a second light reflector 11 disposed in the hole H, overlapping the first light reflector 10, and below the first light reflector 10. The second light reflector 11 overlaps the first light reflector 10 in plan view. A first electrode E1 can be provided above the compound semiconductor part 9. The mask pattern 6 includes an opening portion K and a mask portion 5. The mask pattern 6 may be a mask layer 6, the base semiconductor part 8 may be a base semiconductor part layer 8, and the compound semiconductor part 9 may be a compound semiconductor part layer 9. The semiconductor substrate 15 needs to include the main substrate 1 (for example, a bulk crystal substrate) and a semiconductor portion (a semiconductor layer), and the main substrate 1 may be a semiconductor or a non-semiconductor. For convenience of description, a direction from the main substrate 1 toward the base semiconductor part 8 is referred to as an "upward direction" (which may, therefore, be different from the vertically upward direction or the upward direction in the drawing).

The semiconductor substrate 15 includes a hole H that penetrates the main substrate 1 in the thickness direction (Z-direction, vertical direction) and overlaps the base semiconductor part 8 and the compound semiconductor part 9 in plan view. Two components overlapping each other in plan view means that at least a part of one component overlaps the other component when viewed (including perspective viewing) in the normal direction of the main substrate 1.

The first light reflector 10 and the first electrode E1 may overlap in plan view. At least a part of the second light reflector 11 may be formed in the hole H. The second light reflector 11, the base semiconductor part 8, the compound semiconductor part 9, the first electrode E1, and the first light reflector 10 may overlap each other in plan view. In the semiconductor device 30, laser oscillation is enabled when the light generated in the compound semiconductor part 9 reciprocates between the first and second light reflectors 10, 11, and is emitted from, for example, the second light reflector 11 as laser light. In the semiconductor device 30, the second light reflector 11 provided in the hole H of the main substrate 1 increases heat dissipation and improves the reliability of the semiconductor device 30.

In the semiconductor device 30, even when the main substrate 1 and the base semiconductor part 8 have different lattice constants, threading dislocations (defects) in the base semiconductor part 8 and the compound semiconductor part 9 are reduced on the mask portion 5. This enhances the light emission efficiency of the compound semiconductor part 9 (for example, the ratio of the amount of light to the amount of charge injected from the first electrode E1). This is due to the fact that the threading dislocations are dislocations (defects) that extend from the base semiconductor part 8 to the compound semiconductor part 9, suppressing charge transfer and causing heat generation.

The base semiconductor part 8 and the compound semiconductor part 9 include, for example, a nitride semiconductor. The nitride semiconductor may be expressed, for example, by AlₓGa_{y}In_{z}N (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN. The base semiconductor part 8 may be of a doped type (for example, an n-type including a donor) or a non-doped type. The base semiconductor part 8 and the compound semiconductor part 9 may be nitride semiconductor layers.

The base semiconductor part 8 including a nitride semiconductor may be formed by an epitaxial lateral overgrowth (ELO) method, but may alternatively be formed by another method that can achieve low defects. In the ELO method, for example, a different substrate having a lattice constant different from that of the base semiconductor part 8 is used as the main substrate 1, and an inorganic compound film is used for the mask portion 5 to expose the upper surface of a base portion 4 from the opening portion K, thus allowing the growth of the base semiconductor part 8 in the lateral direction (Y-direction) on the mask portion 5.

In the following, the main substrate 1 and the base portion 4 may be collectively referred to as a base substrate, and the main substrate 1, the base portion 4, and the mask pattern 6 may be collectively referred to as a template substrate 7. In addition, the semiconductor layer (semiconductor portion) formed by the ELO method may be referred to as an ELO semiconductor layer.

### Manufacturing Semiconductor Device

FIG. 2 is a flowchart illustrating an example of a method for manufacturing a semiconductor device according to the present embodiment. In the method for manufacturing the semiconductor device in FIG. 2, after the template substrate (substrate for ELO growth) 7 is prepared, the base semiconductor part 8 is formed using the ELO method, the compound semiconductor part 9 is formed, the first light reflector 10 is formed, and the second light reflector 11 is formed.

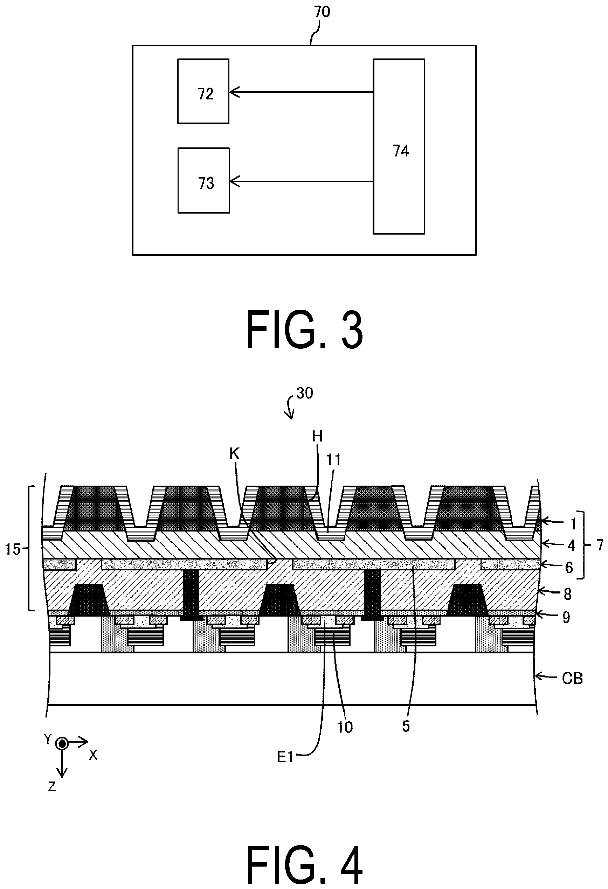

FIG. 3 is a block diagram illustrating an example of an apparatus for manufacturing the semiconductor device according to the present embodiment. An apparatus for manufacturing the semiconductor device 70 in FIG. 3 includes a film forming unit 72 configured to form the base semiconductor part 8, the compound semiconductor part 9, the first light reflector 10, and the second light reflector 11 on the template substrate 7, a processing unit 73 configured to perform etching of the main substrate 1 from a back surface 1U thereof, and a control unit 74 configured to control the film forming unit 72 and the processing unit 73.

The film forming unit 72 may include a metal organic chemical vapor deposition (MOCVD) apparatus, and the control unit 74 may include a processor and a memory. The control unit 74 may be configured to control the film forming unit 72 and the processing unit 73 by executing a program stored in, for example, a built-in memory or a communicable communication device, or on an accessible network. The program and a recording medium or the like in which the program is stored are also included in the present embodiment.

### Semiconductor Device

FIG. 4 is a cross-sectional view illustrating another configuration of the semiconductor device according to the present embodiment. As illustrated in FIG. 4, the semiconductor device 30 includes a circuit board CB disposed on the opposite side of the main substrate 1 and electrically connected to the first electrode E1.

### Example 1

### Overall Configuration

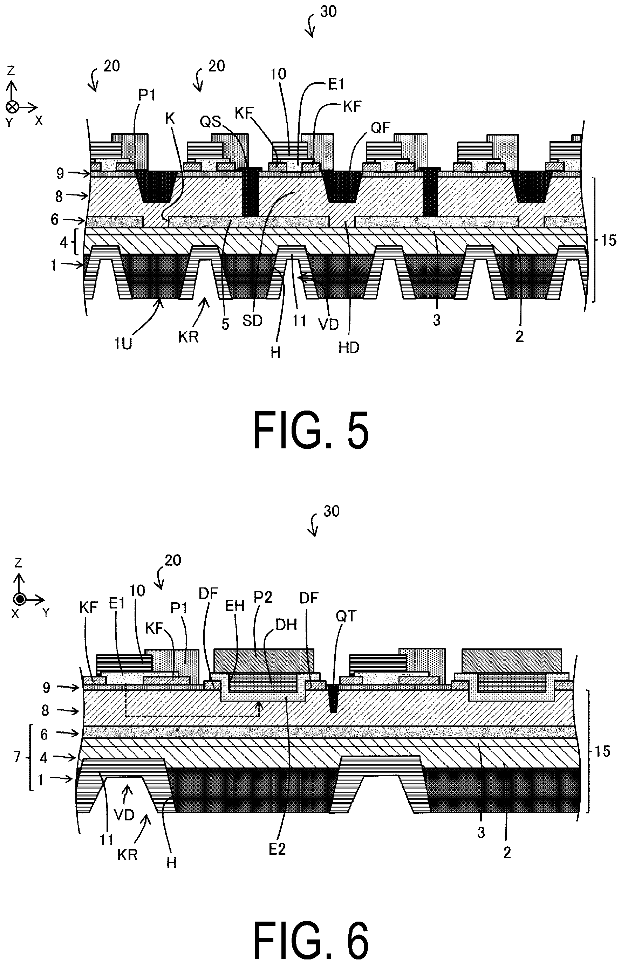

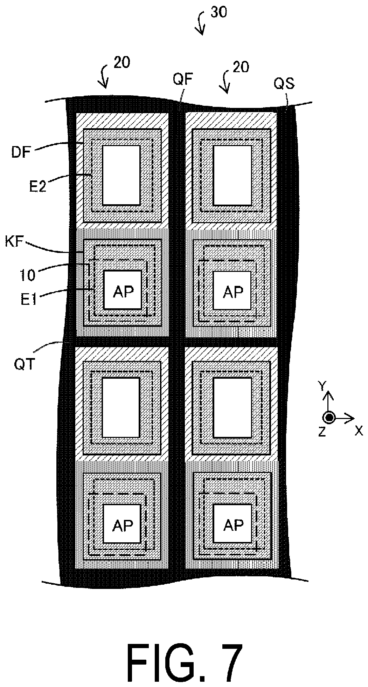

FIG. 5 is a cross-sectional view of the semiconductor device in the X-direction according to Example 1. FIG. 6 is a cross-sectional view of the semiconductor device in the Y-direction according to Example 1. FIG. 7 is a plan view of the semiconductor device according to Example 1. As illustrated in FIGs. 5, 6, and 7, the semiconductor device 30 according to Example 1 includes (i) the semiconductor substrate 15 including the main substrate 1, the base portion 4 located on the main substrate 1, the mask pattern 6 located on the base portion 4 and including the mask portion 5 and the opening portion K, the base semiconductor part 8 located on the mask pattern 6, and the hole H penetrating the main substrate 1, (ii) the compound semiconductor part 9 located on the base semiconductor part 8, (iii) an insulating film KF located on the compound semiconductor part 9, (iv) the first electrode E1 and the second electrode E2, (v) the first light reflector 10 located on the first electrode E1, and (vi) the second light reflector 11 provided in the hole H. The base semiconductor part 8 and the compound semiconductor part 9 may include nitride semiconductors (for example, GaN-based semiconductors). For example, the X-direction is the <11-20> direction of the base semiconductor part 8, the Y-direction is the <1-100> direction of the base semiconductor part 8, and the Z-direction is the <0001> direction of the base semiconductor part 8.

The main substrate 1 is a different substrate having a lattice constant different from that of the base semiconductor part 8. The main substrate 1 may be a light-shielding substrate, such as a silicon substrate. The semiconductor substrate 15 includes the hole H configured to penetrate through the lower and upper surfaces of the main substrate 1 and overlap the compound semiconductor part 9 in plan view. The hole H may be tapered toward the base semiconductor part 8. The second light reflector 11 provided in the hole H may overlap the first light reflector 10 in plan view. The second light reflector 11 may be in contact with at least the bottom (bottom surface) of the hole H or may be in contact with the side wall of the hole H.

The hole H has an opening KR formed on the back surface (lower surface) 1U of the main substrate 1 and serving as an emission surface for the laser light. The shape of the opening KR may be a rectangle, a rhombus, a hexagon, a circle, an ellipse, or the like, but is not limited thereto. In Example 1, at least a part of the bottom portion of the hole H is included in the base portion 4. As illustrated in FIG. 5, the entire bottom portion of the hole H may be located in the base portion 4.

The first electrode E1 is an anode provided on the compound semiconductor part 9. The compound semiconductor part 9 is provided on the base semiconductor part 8, but the compound semiconductor part 9 is not provided above a part of the base semiconductor part 8. The second electrode E2, therefore, can be provided so as to be in contact with the part of the base semiconductor part 8. The first electrode E1 may have light permeability.

The semiconductor device 30 includes one or more surface emitting semiconductor laser elements (vertical cavity surface emitting laser (VCSEL) elements) 20, each including the base semiconductor part 8, the compound semiconductor part 9, the insulating film KF, the first and second electrodes E1, E2, and the first and second light reflectors 10, 11. Specifically, the light generated in the compound semiconductor part 9 by the current between the first and second electrodes E1 and E2 oscillates in the laser due to induced emission and feedback effects between the first and second light reflectors 10, 11, and is emitted as laser light from, for example, the second light reflector 11. In the semiconductor device 30, the second light reflector 11 provided in the hole H of the main substrate 1 increases heat dissipation and improves reliability. The second light reflector 11 may be in contact with a void portion VD in the hole H. The main substrate 1 maintains the rigidity of the semiconductor device. The second light reflector 11 may extend to the back surface of the main substrate 1.

The insulating film KF is provided between the peripheral end portion of the first electrode E1 and the compound semiconductor part 9. The insulating film KF constricts the current path between the first and second electrodes E1, E2 on the anode side, thus enhancing the light emission efficiency (see below).

The base semiconductor part 8 can be made of an n-type semiconductor (for example, silicon-doped gallium nitride). The base semiconductor part 8 includes a first portion HD located on the opening portion K and a second portion (low-defect portion) SD located on the mask portion 5 and having a threading dislocation density of 5 x 10⁶/cm² or less, the second portion SD overlapping the compound semiconductor part 9 in plan view. A part of the compound semiconductor part 9 overlapping the second portion SD in plan view is a low-dislocation portion inheriting the low-dislocation characteristic (low-defect characteristic), and thus the light emission efficiency in this part can be increased.

In Example 1, the first and second electrodes E1, E2 are arranged in the Y-direction. For example, a transparent electrode including indium tin oxide (ITO) or the like can be used as the first electrode E1, and a light reflective electrode can be used as the second electrode E2. The compound semiconductor part 9 may include a GaN-based semiconductor, and the first electrode E1 may include gallium oxide.

The semiconductor device 30 includes a first pad P1 in contact with the upper surface of the first electrode E1 and a second pad P2 in contact with the upper surface of the second electrode E2. In plan view, at least a part of the first pad P1 does not overlap the hole H. This reduces the impact of the pressure applied to the first pad P1 against the compound semiconductor part 9 and the base semiconductor part 8. In FIG. 7, the first and second pads P1, P2 described later are omitted in order to clearly indicate the position of each component on the compound semiconductor part 9.

In plan view, at least a part of the second pad P2 does not overlap the hole H. This reduces the impact of the pressure applied to the second pad P2 (for example, the pressure during bonding with the circuit board CB) against the compound semiconductor part 9 and the base semiconductor part 8. In addition, at least a part of the first pad P1 does not overlap the hole H in plan view. This reduces the impact of the pressure applied to the first pad P1 against the compound semiconductor part 9 and the base semiconductor part 8. The first pad P1 may be in contact with the upper surface of the first light reflector 10. The thermal conductivity of the first pad P 1 is higher than that of the first light reflector 10, increasing the heat dissipation characteristic.

In the semiconductor device 30, the upper surface levels (height positions) of the first and second pads P 1, P2 coincide with each other, and the upper surfaces of the first and second pads P1, P2 are located higher than the upper surface of the first light reflector 10. This facilitates mounting on the circuit board CB (see FIG. 4).

An insulating film DF may be provided between the peripheral portion of the second electrode E2 and the base semiconductor part 8. The insulating film DF suppresses contact between the second electrode E2 and the compound semiconductor part 9 and electrically separates the second electrode E2 and the compound semiconductor part 9. The second electrode E2 may have a recessed portion EH, and the recessed portion EH may be filled with an insulating body DH. The insulating body DH can flatten the upper surface of the second pad P2.

The semiconductor device 30 includes a first partition wall portion QF overlapping the opening portion K of the mask pattern 6 in plan view, a second partition wall portion QS overlapping the mask portion 5 of the mask pattern 6 in plan view, and a third partition wall portion QT dividing the compound semiconductor part 9 in the Y-direction. The first partition wall portion QF, the second partition wall portion QS, and the third partition wall portion QT may have light reflectivity. The first partition wall portion QF and the second partition wall portion QS extend in the Y-direction, and the third partition wall portion QT extends in the X-direction.

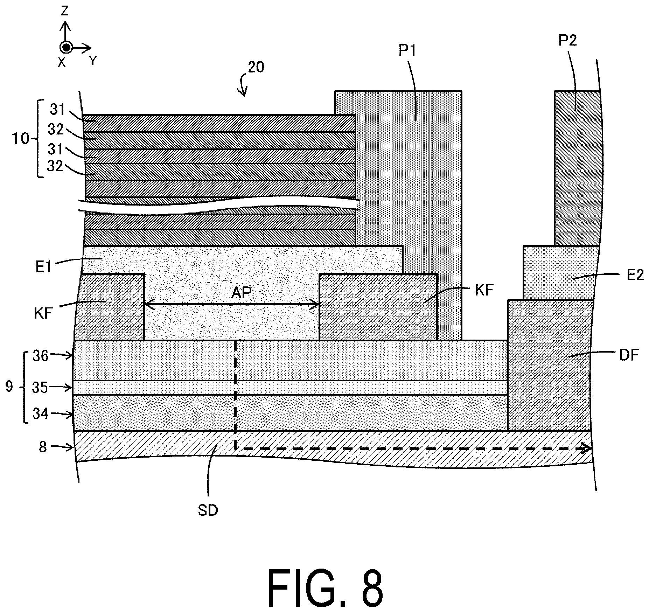

FIG. 8 is a partial enlarged view of the semiconductor device 30 illustrated in FIG. 6. As illustrated in FIG. 8, the compound semiconductor part 9 includes an n-type semiconductor layer 34 as a first type semiconductor layer, an active layer 35, and a p-type semiconductor layer 36 as a second type semiconductor layer in this order from the lower layer side. The active layer 35 has, for example, a multi-quantum well (MQW) structure and may include an InGaN layer and a GaN layer. The n-type semiconductor layer 34 includes, for example, an n-GaN layer and/or an n-AlGaN layer. The p-type semiconductor layer 36 includes, for example, a p-GaN layer and/or a p-AlGaN layer. The first electrode E1 serving as the anode is disposed so as to be in contact with the p-type semiconductor portion 36.

The insulating film KF formed on the p-type semiconductor layer 36 includes an aperture portion AP (current constriction portion) in which the first electrode E1 is in contact with the p-type semiconductor layer 36 exposed from the aperture portion AP. For the insulating film KF, SiOx, SiNx, AlOx, or the like can be used.

In Example 1, the aperture portion AP overlaps the first light reflector 10, the compound semiconductor part 9, the second portion SD (low-defect portion) of the base semiconductor part 8, and the second light reflector 11 in plan view. That is, a current path (particularly, a current constriction portion) from the first electrode E1 to the base semiconductor part 8 is formed in the low-defect portion of the base semiconductor part 8 and the compound semiconductor part 9. This enhances the light emission efficiency of the active layer 35. The area of the bottom surface of the hole H in which the second light reflector 11 is formed may be larger than the area of the aperture portion AP.

The insulating film DF suppresses direct contact between the second electrode E2 and the compound semiconductor part 9, and in particular, between the second electrode E2 and the p-type semiconductor portion 36. This reduces the risk of holes injected from the first electrode E1 into the p-type semiconductor portion 36 moving to the second electrode E2 without passing through the active layer 35.

A part of the compound semiconductor part 9 may be dug in by etching or the like to expose the base semiconductor part 8 to allow the second electrode E2 to be provided in contact with the base semiconductor part 8. Alternatively, a part of the compound semiconductor part 9 may be dug in by etching or the like to expose, for example, the n-type semiconductor layer 34 in the compound semiconductor part 9 to allow the second electrode E2 to be provided in contact with the n-type semiconductor layer 34.

For example, as illustrated in FIG. 8, the first light reflector 10 is a reflecting mirror (for example, a distributed Bragg reflector) in which low-refraction portions 31 and high-refraction portions 32 are alternately stacked. The low-refraction portion 31 may be a first refraction portion, and the high-refraction portion 32 may be a second refraction portion having a higher optical refractive index than the first refraction portion. The low-refraction portion 31 includes, for example, SiO₂. The high-refraction portion 32 is a layer including a material having a refractive index higher than that of the low-refraction portion 31, and includes, for example, TazOs, HfO₂, ZrO₂, TiO₂, Al₂O₃, Nb₂O₅, ZnO, AlN, SiN, or MgO. At an interface between the high-refraction portion 32 and the low-refraction portion 31, the light incident on the interface at an angle equal to or greater than the critical angle is totally reflected at the interface, achieving a high light reflectance in the first light reflector 10. The second light reflector 11 may have the structure (DBR) the same as or similar to that of the first light reflector 10.

Here, with respect to the emission wavelength from the active layer 35, the first light reflector 10 may have a reflectance of substantially 100%, for example, about 99%, and the second light reflector 11 may have a reflectance lower than that of the first light reflector 10, for example, about 98%. In this case, the light reciprocating between the first light reflector 10 and the second light reflector 11 is emitted as the laser light from the opening KR of the main substrate 1. Since the first partition wall portion QF and the second partition wall portion QS have light reflectivity, the utilization efficiency of light increases.

The configuration is not limited to one in which the laser light is emitted from the second light reflector 11 side (hole H). The configuration may be such that the laser light is emitted from the first light reflector 10 side or from each of the first and second light reflectors 10, 11.

### Manufacturing Method

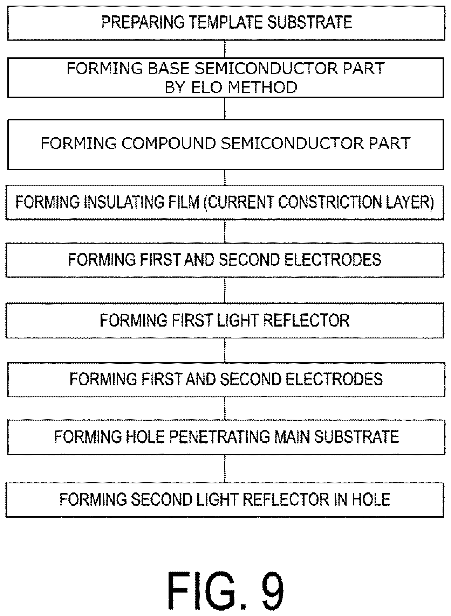

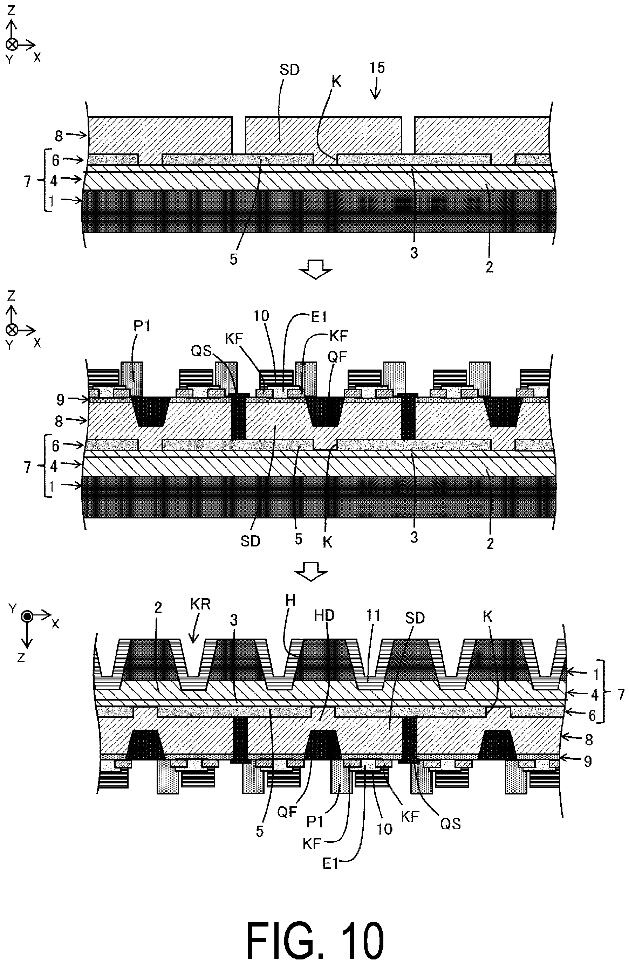

FIG. 9 is a flowchart illustrating an example of a method for manufacturing the semiconductor device according to Example 1. FIG. 10 illustrates cross-sectional views of steps of an example of the method for manufacturing the semiconductor device according to Example 1. As illustrated in FIGs. 9 and 10, in the method for manufacturing the semiconductor device, the template substrate 7 is prepared, and then the base semiconductor part 8 is formed by the ELO method. Subsequently, the compound semiconductor part 9 is formed, and then the insulating film DF and the first and second electrodes E1, E2 are formed. Subsequently, the first light reflector 10 is formed, and then the first and second pads P1, P2 are formed. Subsequently, the main substrate 1 is etched from the back surface 1U to form the hole H. Subsequently, the second light reflector 11 is formed in the hole H. After the ELO film formation is performed using the mask pattern 6, the mask portion 5 may be removed by wet etching or the like, for example, before the first and second electrodes E1, E2 are formed.

### Main Substrate

A heterogeneous substrate having a different lattice constant from that of a GaN-based semiconductor may be used for the main substrate 1. Examples of the heterogeneous substrate include a single crystal silicon (Si) substrate, a sapphire (Al₂O₃) substrate, and a silicon carbide (SiC) substrate. The plane orientation of the main substrate 1 is, for example, the (111) plane of the silicon substrate, the (0001) plane of the sapphire substrate, or the 6H-SiC (0001) plane of the SiC substrate. These are merely examples, and any main substrate and plane orientation allowing the growth of the base semiconductor part 8 by the ELO method may be used. A Si substrate or a SiC substrate may be adopted as the main substrate 1 from the viewpoint of having a better thermal conductivity than the GaN bulk substrate.

### Base Portion

As the base portion 4, a buffer portion (buffer layer) 2 and a seed portion 3 can be provided in this order from the main substrate 1 side. The buffer portion 2 has a function of, for example, reducing the likelihood of the main substrate 1 and the seed portion 3 coming into contact and melting into each other. For example, when a silicon substrate is used as the main substrate 1 and a GaN-based semiconductor is used for the seed portion 3, the two (main substrate and seed portion) melt together. The melting can be reduced by providing the buffer portion 2 containing, for example, an AlN layer and/or a SiC (silicon carbide) layer. The AlN layer which is an example of the buffer portion 2 can be formed using an MOCVD apparatus, for example, to have a thickness of from about 10 nm to about 5 µm (for example, 150 nm). The buffer portion 2 may have at least one of the effect of improving the crystallinity of the seed portion 3, the effect of relaxing the internal stress of the base semiconductor part 8 (relaxing the warp of the semiconductor device 30), and the effect of increasing the heat dissipation. When the main substrate 1 that does not melt with the seed portion 3 is used, the buffer portion 2 need not be provided. From the viewpoint of excellent thermal conductivity, a SiC layer may be adopted for the seed portion 3 or the buffer portion 2. As illustrated in FIG. 5, the configuration is not limited to one in which the seed portion 3 overlaps the entirety of the mask portion 5. Since the seed portion 3 needs to be exposed from the opening portion K of the mask 6, the seed portion 3 may be locally formed so as not to overlap at least a part of the mask portion 5.

The buffer portion 2 (for example, aluminum nitride) and/or the seed portion 3 (for example, GaN-based semiconductor) may be used for film formation using a sputtering apparatus (for example, pulse sputter deposition (PSD), pulse laser deposition (PLD), or the like).

### Mask Pattern

The opening portion K in the mask pattern 6 functions as a growth initiation hole to expose the seed portion 3 and initiate the growth of the base semiconductor part 8. The mask portion 5 in the mask pattern 6 functions as a selective growth mask for lateral growth of the base semiconductor part 8.

The mask pattern 6 may be removed after the base semiconductor part 8 is formed (ELO film formation). The opening portion K is a portion where the mask portion 5 is not provided, and the opening portion K need not be surrounded by the mask portion 5.

Examples of the mask portion 5 that can be used include a single-layer film including any one of a silicon oxide film (SiOₓ), a titanium nitride film (TiN or the like), a silicon nitride film (SiNₓ), a silicon oxynitride film (SiON), and a metal film having a high melting point (for example, 1000°C or higher), or a layered film including at least two of these.

For example, a silicon oxide film having a thickness of from about 100 nm to about 4 µm (preferably from about 150 nm to about 2 µm) is formed on the entire surface of the base portion 4 by sputtering, and a resist is applied onto the entire surface of the silicon oxide film. Subsequently, the resist is patterned by photolithography to form the resist with a plurality of stripe-shaped opening portions. Subsequently, a part of the silicon oxide film is removed with a wet etchant such as a hydrofluoric acid (HF) or a buffered hydrofluoric acid (BHF) to form a plurality of opening portions K, and the resist is removed by organic cleaning. Thus, the mask pattern 6 is formed.

The opening portion K has a longitudinal shape (slit shape) and is periodically arranged in an a-axis direction (X-direction) of the base semiconductor part layer 8. The width (opening width) of the opening portion K can be set to about 0.1 µm to 20 µm. As the width of each opening portion decreases, the number of threading dislocations propagating from each opening portion to the base semiconductor part 8 decreases. In addition, the low-defect portion SD can be made large.

The silicon oxide film may decompose and evaporate in minute amounts during film formation of the base semiconductor part 8 and may be taken into the base semiconductor part 8. However, silicon nitride and silicon oxynitride films have the advantage of being difficult to decompose and evaporate at high temperatures.

Therefore, the mask portion 5 may be a single-layer film of a silicon nitride or silicon oxynitride film, a layered film in which a silicon oxide film and a silicon nitride film are formed in this order on the base portion 4, a laminate film in which a silicon nitride film and a silicon oxide film are formed in this order on the base portion 4, or a layered film in which a silicon nitride film, a silicon oxide film, and a silicon nitride film are formed in this order on the base portion 4.

An abnormal portion such as a pinhole in the mask portion 5 may be eliminated by performing organic cleaning or the like after film formation and introducing the film again into a film forming device to form the same type of film. The mask pattern 6 with a high quality may be formed by using a general silicon oxide film (single layer) and using the above-described re-film formation method.

### Specific Example of Template Substrate

A silicon substrate having the (111) plane was used for the main substrate 1, and the buffer portion 2 of the base portion 4 was an AlN layer (for example, 30 nm). The seed portion 3 of the base portion 4 was a graded layer in which a first layer of an Al_{0.6}Ga_{0.4}N layer (for example, 300 nm) and a second layer of a GaN layer (for example, 1 to 2 µm) were formed in this order.

A laminate body in which a silicon oxide film (SiO₂) and a silicon nitride film (SiN) were formed in this order was used for the mask portion 5. The thickness of the silicon oxide film was, for example, 0.3 µm, and the thickness of the silicon nitride film was, for example, 70 nm. Plasma chemical vapor deposition (CVD) was used for film formation of the silicon oxide film and the silicon nitride film, respectively.

### Base semiconductor part

In Example 1, the GaN layer was provided as the base semiconductor part (ELO semiconductor layer) 8, and the ELO film formation of gallium nitride (GaN) was performed on the template substrate 7 described above using the MOCVD apparatus. The following may be adopted as examples of the ELO film formation conditions: substrate temperature: 1120°C, growth pressure: 50 kPa, trimethylgallium (TMG): 22 sccm, NH₃: 15 slm, and V/III = 6000 (ratio of group V raw material supply amount to group III raw material supply amount).

In this case, the base semiconductor part 8 was selectively grown (vertically grown) on the seed portion 3 (for example, the GaN layer) exposed from the opening portion K, and was subsequently grown laterally on the mask portion 5. The lateral growth was stopped before portions of the base semiconductor part 8 laterally growing from both sides on the mask portion 5 met.

A width Wm of the mask portion 5 was 50 µm, the width of the opening portion K was 5 µm, the lateral width of the base semiconductor part 8 was 53 µm, the width (size in the X-direction) of the low-defect portion SD was 24 µm, and the layer thickness of the base semiconductor part 8 was 5 µm. Thus, the aspect ratio of the base semiconductor part 8 was 53 µm/5 µm = 10.6; achieving a very high aspect ratio.

In Example 1, the lateral film formation rate is increased in the formation of the base semiconductor part 8. A method for increasing the lateral film formation rate is as follows. First, a vertical growth layer growing in the Z-direction (c-axis direction) is formed on the seed portion 3 exposed from the opening portion K, followed by a lateral growth layer growing in the X-direction (a-axis direction). In this case, by setting the thickness of the vertical growth layer to 10 µm or less, preferably 5 µm or less, and more preferably 3 µm or less, the thickness of the lateral growth layer may be suppressed to be thin and the lateral film formation rate may be increased.

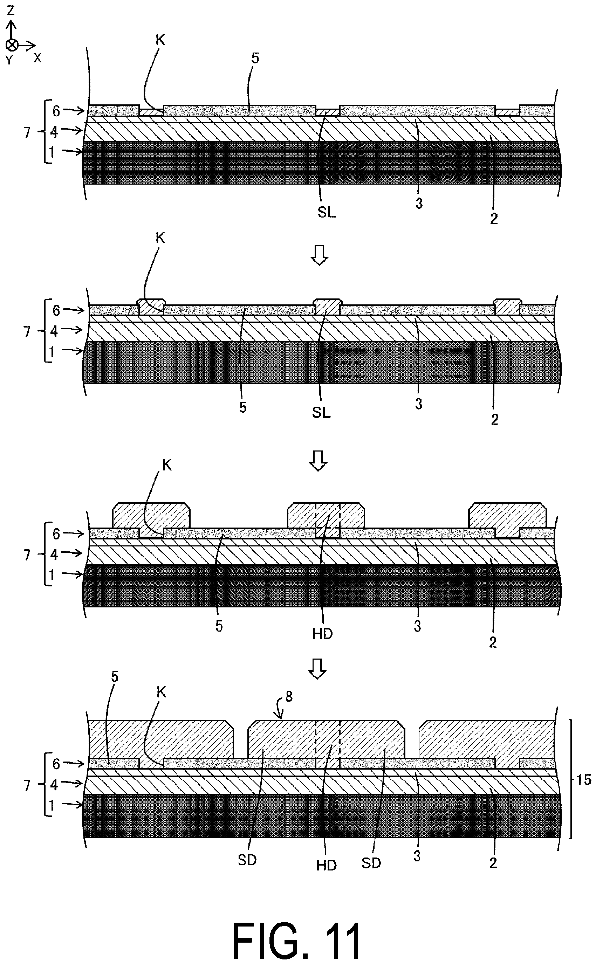

FIG. 11 illustrates cross-sectional views of an example of the lateral growth of the base semiconductor part 8. As illustrated in FIG. 11, an initial growth layer SL is formed on the seed portion 3, and then the base semiconductor part 8 can be grown laterally from the initial growth layer SL. The initial growth layer SL serves as a start point of the lateral growth of the base semiconductor part 8. By appropriately controlling the ELO film formation conditions, the base semiconductor part 8 can be controlled to grow in the Z-direction (c-axis direction) or in the X-direction (a-axis direction).

Here, the film formation of the initial growth layer SL may be stopped just before the edge of the initial growth layer SL rides up to the upper surface of the mask portion 5 (when it is in contact with the top edge of the side surface of the mask portion 5) or just after it rides up to the upper surface of the mask portion 5 (that is, the ELO film formation conditions may be switched from the film formation conditions in the c-axis direction to the film formation conditions in the a-axis direction at this timing). In this way, the initial growth layer SL protrudes slightly from the mask portion 5 before lateral film formation is performed, reducing the amount of material consumed for growth in the thickness direction of the base semiconductor part 8 and allowing the base semiconductor part 8 to be grown laterally at high speed. The initial growth layer SL may be formed to have a thickness of, for example, 2.0 µm or more and 3.0 µm or less.

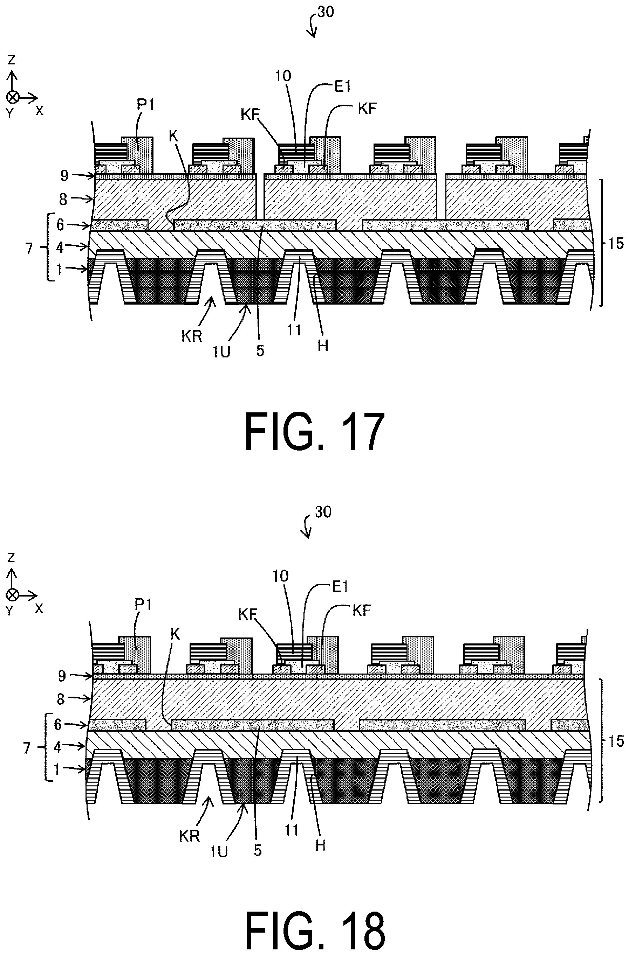

In Example 1, the lateral growth is stopped before portions of the base semiconductor part 8 laterally growing from both sides on the mask portion 5 meet, but the configuration is not limited thereto. The lateral growth may be stopped after portions of the base semiconductor part 8, which grow laterally from both sides of the mask portion 5, meet (see FIG. 18). In this case, since the number of dislocations (crystal defects) in the meeting portion increases, the aperture portion AP of the semiconductor laser element 20 is configured not to overlap the meeting portion in plan view.

When the base semiconductor part 8 is formed using the ELO method, the template substrate 7 including the main substrate 1 and the mask pattern 6 on the main substrate 1 may be used. The template substrate 7 may include a growth suppression region (for example, a region that suppresses crystal growth in the Z-direction) corresponding to the mask portion 5 and the seed region corresponding to the opening portion K. For example, the growth suppression region and the seed region can be formed on the main substrate 1, and the base semiconductor part 8 can be formed on the growth suppression region and the seed region using the ELO method.

### Compound semiconductor part and Electrode

The base semiconductor part 8 and the compound semiconductor part 9 may be formed successively with the same device (for example, the MOCVD apparatus). Alternatively, the substrate may be taken out of the device after the base semiconductor part 8 is formed, and the compound semiconductor part 9 is formed after treating the surface of the base semiconductor part 8 by, for example, polishing. In this case, the compound semiconductor part 9 may be formed after the n-type GaN-based semiconductor layer (for example, having a thickness of about 0.1 µm to about 3 µm) serving as a buffer during regrowth is formed on the base semiconductor part 8. In addition to the MOCVD apparatus, a sputtering apparatus, a remote plasma CVD (RPCVD) apparatus, a pulse sputter deposition (PSD) apparatus, and the like can be used to form the compound semiconductor part 9. Because the remote plasma CVD apparatus and the PSD apparatus do not use hydrogen as a carrier gas, the low-resistance p-type GaN-based semiconductor portion can be formed.

The MQW structure of the active layer 35 may be, for example, a five to six period structure of InGaN/GaN. The composition of In varies with the desired emission wavelength, with an In concentration of about 15 to 20% for blue (around 450 nm) and about 30% for green (around 530 nm). If necessary, an electron blocking layer (for example, an AlGaN layer) may be formed on the active layer 35. To reduce the resistance, a surface (about 10 nm) of the p-type semiconductor layer 36 may be a p-type highly doped layer.

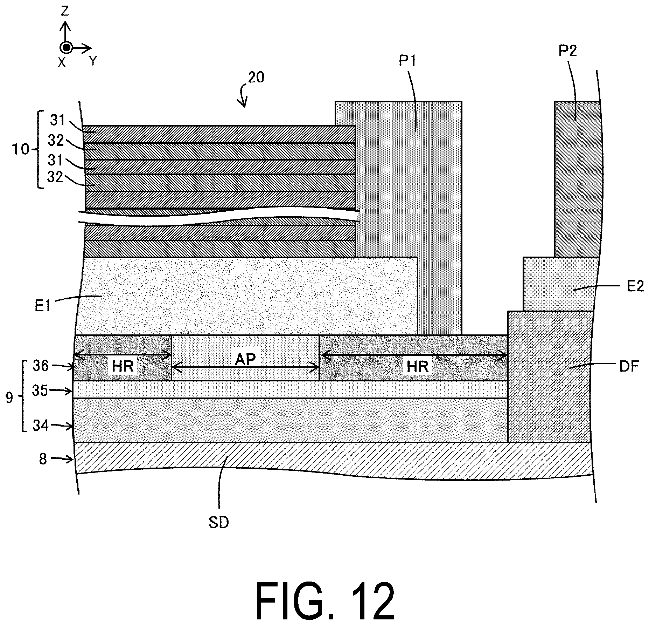

FIG. 12 is a cross-sectional view illustrating another configuration of the semiconductor device of Example 1. Although the aperture portion AP is formed in the insulating film KF in FIG. 8, the configuration is not limited thereto. As illustrated in FIG. 12, the configuration (in which a high-resistance portion HR surrounds the aperture portion AP) may be obtained by providing an annular high-resistance portion HR (region with a low p-type doping concentration) in the p-type semiconductor layer 36, and using the inner side of the high-resistance portion HR as the aperture portion AP (current constriction portion). The high-resistance portion HR may be formed by increasing the resistance of a partial region of the p-type semiconductor layer 36 by ion implantation or the like.

The first electrode E1 is made of a transparent conductive material having light permeability. Examples of the transparent conductive material include indium tin oxide (including crystalline ITO, amorphous ITO, and Sn-doped In₂O₃), indium zinc oxide (IZO), F-doped In₂O₃ (IFO), tin oxide (including SnO₂, Sb-doped SnO₂, and F-doped SnO₂), and zinc oxide (including ZnO, AI-doped ZnO, and B-doped ZnO).

The first electrode E1 may include at least one of gallium (Ga) oxide, titanium (Ti) oxide, niobium (Nb) oxide, and nickel (Ni) oxide as a base layer. The aperture diameter of the first electrode E1 (the diameter of the current injection region in contact with the p-type semiconductor portion) can be, for example, from 2 µm to 100 µm.

The first pad P1 in contact with the first electrode E1 may have a single-layer structure or a multi-layer structure including at least one of Au, Ag, Pd, Pt, Ni, Ti, V, W, Cr, Al, Cu, Zn, Sn, and In. As the multi-layer structure, for example, assuming that the left side indicates the lower layer side, a configuration such as Ti layer/Au layer, Ti layer/Al layer, Ti layer/Al layer/Au layer, Ti layer/Pt layer/Au layer, Ni layer/Au layer, Ni layer/Au layer/Pt layer, Ni layer/Pt layer, Pd layer/Pt layer, or Ag layer/Pd layer can be employed.

### Division

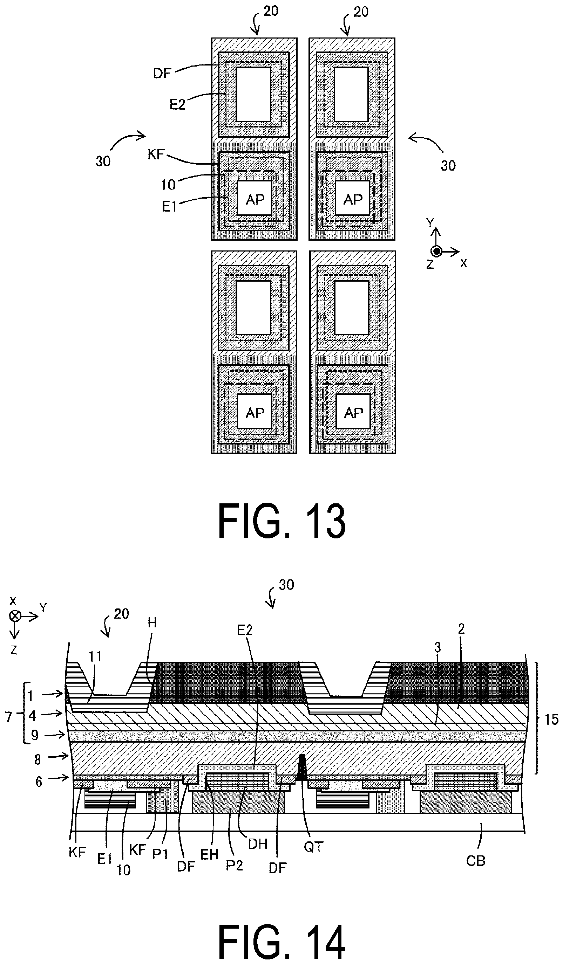

FIG. 13 is a plan view illustrating another configuration of the semiconductor device of Example 1. As illustrated in FIG. 13, The semiconductor device 30 in FIG. 7 may be divided into a plurality of semiconductor devices 30, each including one semiconductor laser element 20. Division may be performed so that each includes a plurality of semiconductor laser elements 20.

### Variation

FIG. 14 is a cross-sectional view illustrating another configuration of the semiconductor device according to Example 1. As illustrated in FIG. 14, the semiconductor device 30 includes the circuit board CB disposed on the opposite side of the main substrate 1 and electrically connected to the first and second pads P1, P2. The circuit board CB may be configured to drive the semiconductor laser elements 20.

The opening KR of the main substrate 1 may be formed after the semiconductor device 30 is bonded to the circuit board CB. When the Si substrate is used as the main substrate 1, the typical thicknesses of the Si substrate is from about 300 µm to about 2. 0 mm. Since it is not easy to form a through hole in a thick Si substrate, the Si substrate (main substrate 1) may be thinned (for example, to a thickness of 300 µm or less) by a method such as wet etching, dry etching, polishing, CMP, or the like after the circuit board CB is bonded to the opposite side of the Si substrate, and then the through hole having the opening KR may be formed. When the semiconductor laser element such as a VCSEL element is manufactured, the depth of the hole H and the size of the opening KR can be set to suppress the hole wall of the main substrate 1 from blocking the emitted laser light.

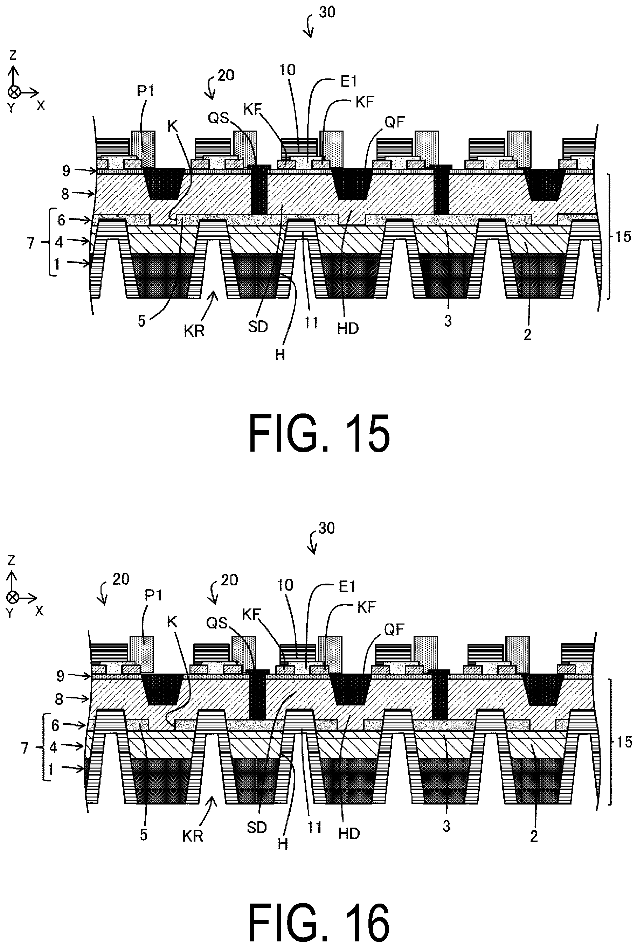

FIGs. 15 and 16 are cross-sectional views each illustrating another configuration of the semiconductor device according to Example 1. In the semiconductor device 30 in FIG. 15, the hole H penetrates the base portion 4, and the bottom portion of the hole H is included in (or in contact with) the mask portion 5. This suppresses propagation of light to the base portion 4. In the semiconductor device 30 in FIG. 16, the hole H penetrates the base portion 4 and the mask portion 5. This suppresses propagation of light to the base portion 4 and the mask portion 5.

In FIG. 16, forming the bottom of the hole H in the base semiconductor part 8 shortens the cavity length and reduces light scattering at the mask portion 5 and the semiconductor interface, resulting in smaller internal loss αi. This enhances the light emission efficiency.

FIGs. 17 and 18 are cross-sectional views each illustrating another configuration of the semiconductor device according to Example 1. As illustrated in FIG. 17, a configuration in which the first partition wall portion QF and the second partition wall portion QS are not provided is also possible. In FIGs. 5, 17, and the like, a plurality of base semiconductor parts 8 and a plurality of compound semiconductor parts 9 are formed, but the configuration is not limited thereto. As illustrated in FIG. 18, portions of the base semiconductor part 8 grown on the mask portion 5 from adjacent opening portions K may be configured to meet and integrate with each other.

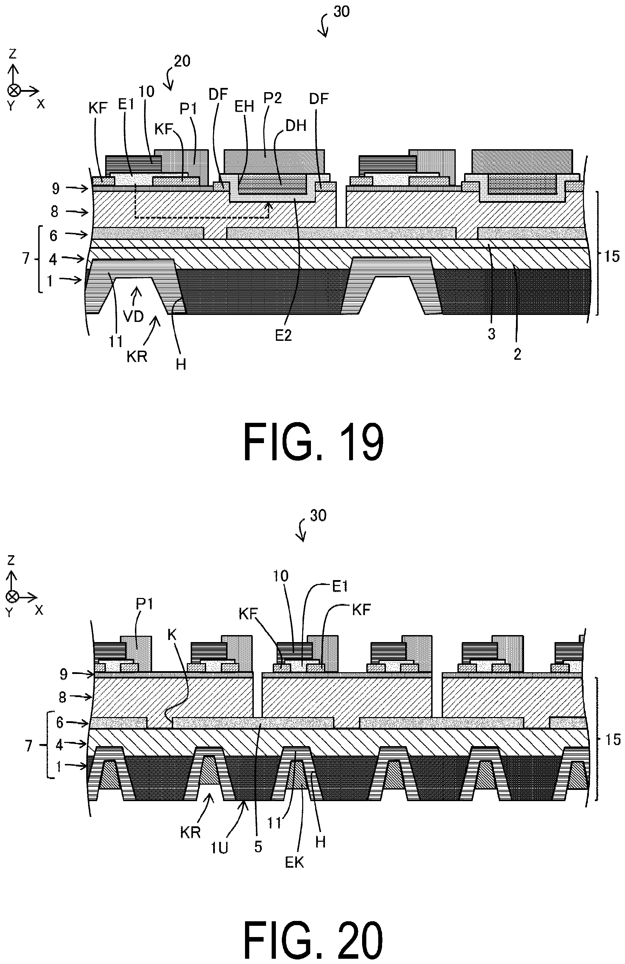

FIG. 19 is a cross-sectional view illustrating another configuration of the semiconductor device according to Example 1. In FIGs. 5, 17, and the like, the first and second electrodes E1, E2 are aligned in the Y-direction (<1-100> direction of the base semiconductor part), but the configuration is not limited thereto. As illustrated in FIG. 19, the first and second electrodes E1, E2 can also be formed and aligned side by side in the X-direction (<1-100> direction of the base semiconductor part).

FIG. 20 is a cross-sectional view illustrating another configuration of the semiconductor device according to Example 1. As illustrated in FIG. 20, a phosphor EK (wavelength converter) may be disposed in the hole H, and the second light reflector 11 may be located closer to the bottom side of the hole H than the phosphor EK. In this manner, light having a wavelength (for example, a visible light range) different from that of light generated in the active layer 35 can be emitted from the opening KR.

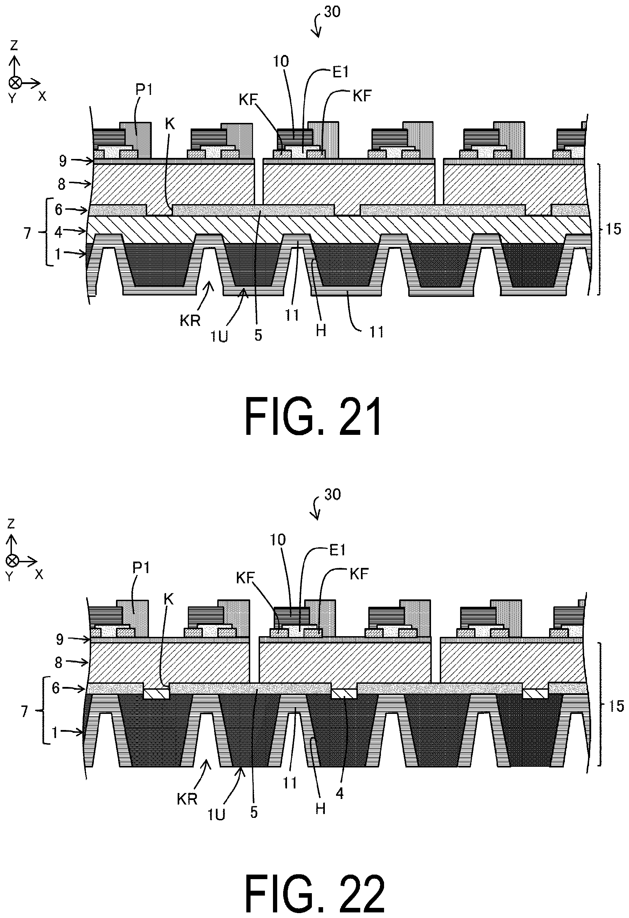

FIG. 21 is a cross-sectional view illustrating another configuration of the semiconductor device according to Example 1. As illustrated in FIG. 21, the second light reflector 11 may be configured to be in contact with the lower surface 1U (a portion other than the hole) of the main substrate 1. This makes it possible to simplify the process.

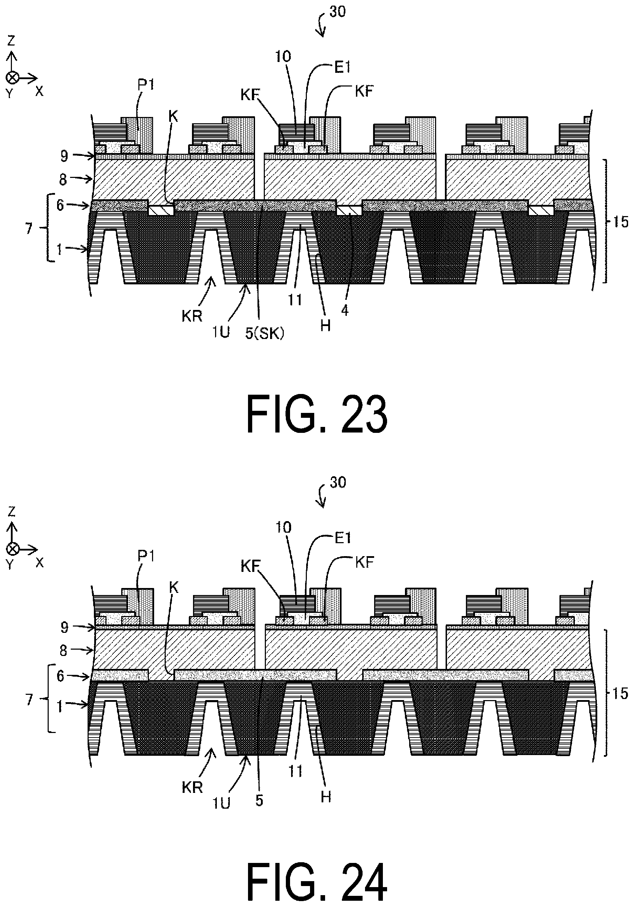

FIGs. 22 and 23 are cross-sectional views each illustrating another configuration of the semiconductor device according to Example 1. As illustrated in FIG. 22, the base portion 4 may be provided locally, not entirely, so as to overlap the opening portion K. This reduces the stress from the base portion 4. In this case, as illustrated in FIG. 23, the mask pattern 6 may be a substrate processed film SK (for example, silicon oxide which is a thermal oxide film of silicon or silicon carbide) obtained by processing the surface (for example, Si or SiC) of the main substrate.

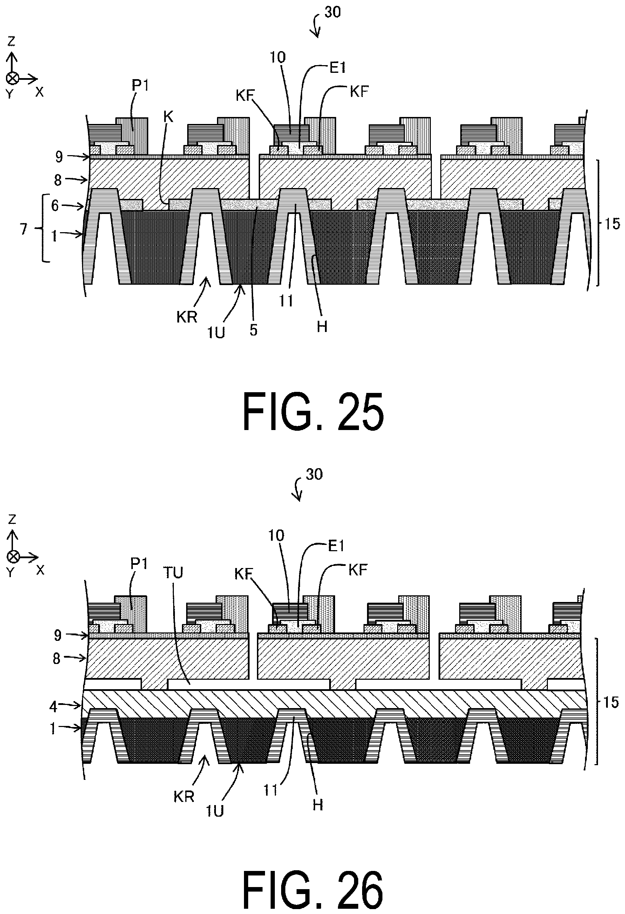

FIGs. 24 and 25 are cross-sectional views each illustrating another configuration of the semiconductor device according to Example 1. The base portion 4 is provided in FIG. 5 and the like, but the configuration is not limited thereto. As illustrated in FIG. 24, by using a GaN substrate (bulk crystal), a 6H-SiC substrate (bulk crystal), or the like, as the main substrate 1, the base semiconductor part 8 can be grown on the main substrate 1 without the base portion 4. In this case, as illustrated in FIG. 25, the bottom of the hole H can be formed inside the base semiconductor part 8.

FIG. 26 is a cross-sectional view illustrating another configuration of the semiconductor device according to Example 1. As illustrated in FIG. 26, the semiconductor device according to Example 1 may be configured without the mask pattern 6 by removing the mask portion 5 after the base semiconductor part 8 is formed. In this case, the lower surface of the base semiconductor part 8 is in contact with the hollow portion TU. The hollow portion TU may include a translucent material different from the growth selection mask. For example, the region between the seed portion 3 or the main substrate 1 and the base semiconductor part 8 may be filled with the translucent material.

### Example 2

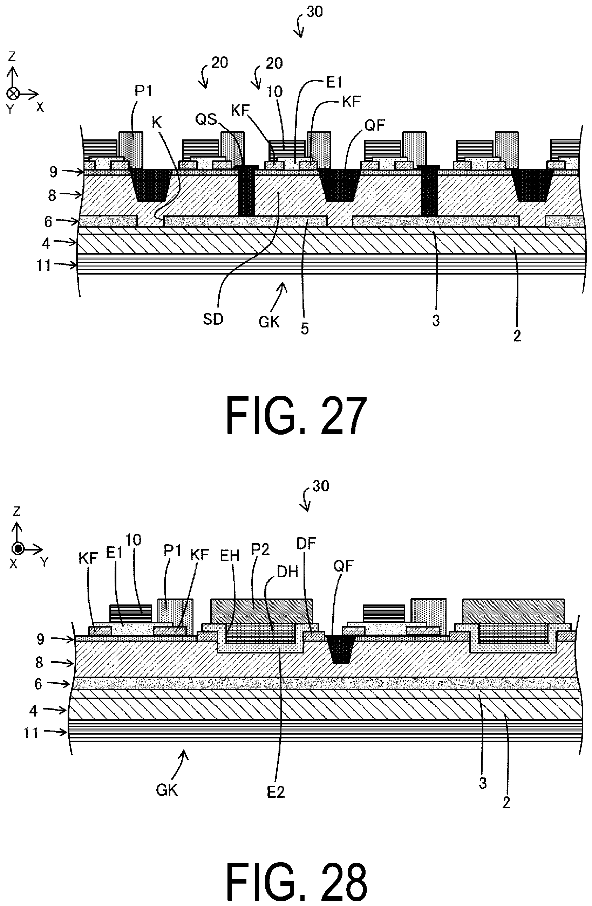

FIG. 27 is a cross-sectional view of a semiconductor device in the X-direction according to Example 2. FIG. 28 is a cross-sectional view of the semiconductor device in the Y-direction according to Example 2. As illustrated in FIGs. 27 and 28, the semiconductor device 30 according to Example 2 includes the seed portion 3, the mask pattern 6 located above the seed portion 3 and including the mask portion 5 and the opening portion K, the base semiconductor part 8 located above the mask pattern 6, the compound semiconductor part 9 located above the base semiconductor part 8, the insulating film KF located above the compound semiconductor part 9, the first electrode E1 and the second electrode E2, the first light reflector 10 located on the first electrode E1, and the second light reflector 11 provided below the base portion 4 and overlapping the first light reflector 10 in plan view. The buffer portion 2 is provided between the main substrate 1 and the seed portion 3, and the base portion 4 includes the buffer portion 2 and the seed portion 3. The buffer portion 2 may be a buffer layer, and the seed portion 3 may be a seed layer. The buffer portion 2 may have a function of suppressing the melting phenomenon caused by the contact between the main substrate 1 and the seed portion 3. The base portion 4 may be constituted by the seed portion 3 without the buffer portion 2. The seed portion 3 may be provided not entirely but locally (for example, in a ridge shape extending in the Y-direction) so as to overlap the opening portion K.

The first electrode E1 is an anode provided on the compound semiconductor part 9. The compound semiconductor part 9 is provided on the base semiconductor part 8, but the compound semiconductor part 9 is not formed above a part of the base semiconductor part 8. The second electrode E2, which is a cathode, is provided so as to be in contact with the part of the base semiconductor part 8. The first electrode E1 has light permeability.

The semiconductor device 30 includes one or more surface emitting semiconductor laser elements (vertical cavity surface emitting laser (VCSEL) elements) 20, each including the base semiconductor part 8, the compound semiconductor part 9, the insulating film KF, the first and second electrodes E1, E2, and the first and second light reflectors 10, 11. Specifically, the light generated in the compound semiconductor part 9 by the current between the first and second electrodes E1 and E2 oscillates in the laser due to induced emission and feedback effects between the first and second light reflectors 10, 11, and is emitted as laser light from, for example, the second light reflector 11. In the semiconductor device 30, the second light reflector 11 is in contact with the lower external space GK, thus increasing heat dissipation and improving reliability.

The insulating film KF is provided between the peripheral end portion of the first electrode E1 and the compound semiconductor part 9. The insulating film KF constricts the current path between the first and second electrodes E1, E2 on the anode side, thus enhancing the light emission efficiency.

The base semiconductor part 8 can be made of an n-type semiconductor (for example, silicon-doped gallium nitride). The base semiconductor part 8 includes a first portion HD located on the opening portion K and a second portion (low-defect portion) SD located on the mask portion 5 and having a threading dislocation density of 5 x 10⁶/cm² or less, the second portion SD overlapping the compound semiconductor part 9 in plan view. A part of the compound semiconductor part 9 overlapping the second portion SD in plan view is a low-dislocation portion inheriting the low-dislocation characteristic (low-defect characteristic), and thus the light emission efficiency in this part can be increased.

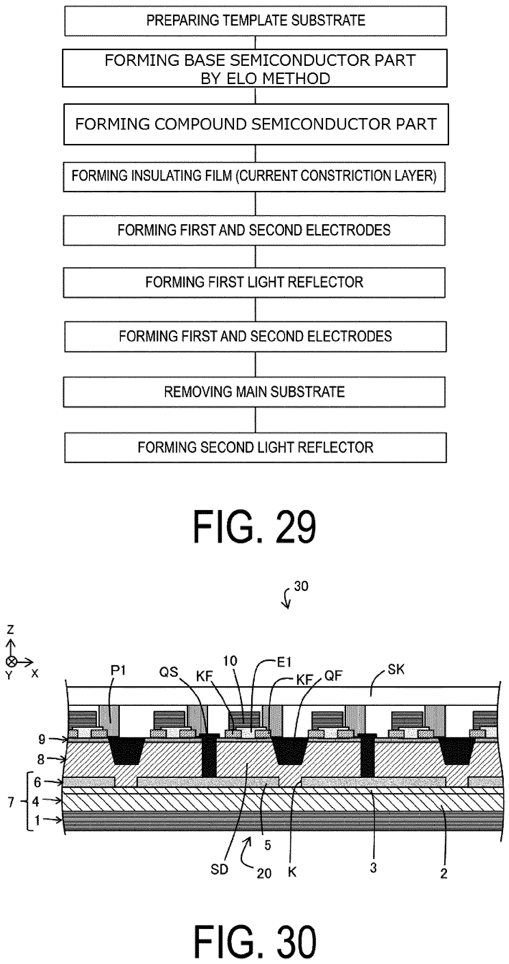

FIG. 29 is a flowchart illustrating an example of a method for manufacturing the semiconductor device of FIG. 27. In the method for manufacturing the semiconductor device of FIG. 29, after preparing the template substrate 7, the base semiconductor part 8 is formed using the ELO method. Subsequently, the compound semiconductor part 9 is formed, and then the insulating film DF (current constriction layer) and the first and second electrodes E1, E2 are formed. Subsequently, the first light reflector 10 is formed, and then the first and second pads P1, P2 are formed. Subsequently, the main substrate 1 is removed by wet or dry etching, polishing, chemical machinery polish (CMP), and the like, and the second light reflector 11 is formed on the opposite side (on the base portion 4) to the side on which the first light reflector 10 is located with reference to the mask pattern 6. The circuit board CB may be bonded before the main substrate 1 is removed. In this way, the mechanical strength of the thinned semiconductor device 30 can be maintained.

FIG. 30 is a cross-sectional view illustrating another configuration of the semiconductor device according to Example 2. As illustrated in FIG. 30, the semiconductor device 30 includes a support substrate SK located above the compound semiconductor part 9. The support substrate SK is disposed on the side opposite to the side on which the first light reflector 11 is located with reference to the mask pattern 6, and is electrically connected to the first and second pads P1, P2. The support substrate SK may be configured as the circuit board that drives the semiconductor laser elements 20.

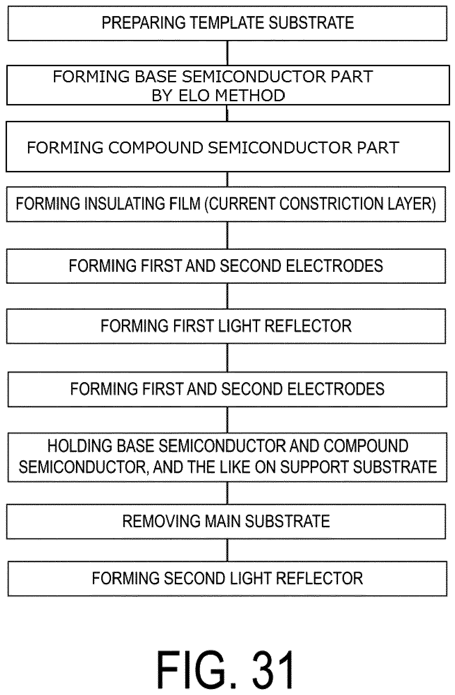

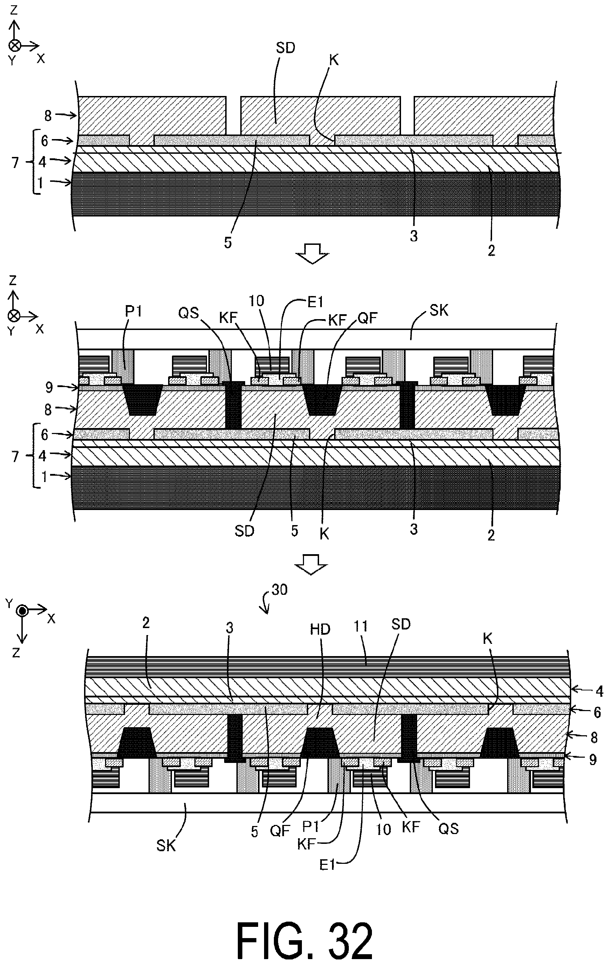

FIG. 31 is a flowchart illustrating an example of a method for manufacturing the semiconductor device of FIG. 30. FIG. 32 illustrates cross-sectional views of steps of an example of the method for manufacturing the semiconductor device of FIG. 30. In the method for manufacturing the semiconductor device of FIG. 30, after the template substrate 7 is prepared, the base semiconductor part 8 is formed using the ELO method. Subsequently, the compound semiconductor part 9 is formed, and then the insulating film DF (current constriction layer), the first and second electrodes E1, E2 are formed, the first light reflector 10 is formed, and the first and second pads P1, P2 are formed. Subsequently, the support substrate SK is bonded to the first and second pads P1, P2 and the base semiconductor part 8, the compound semiconductor part 9, and the like are held on the support substrate SK, the main substrate 1 is removed by wet etching or dry etching, and the second light reflector 11 is formed (on the base portion 4) on the side opposite to the side on which the support substrate SK is located with reference to the mask pattern 6.

### Example 3

The base semiconductor part 8 of Examples 1 and 2 may be made of GaN, but the configuration is not limited thereto. The base semiconductor part 8 may be made of InGaN, which is a GaN-based semiconductor. The InGaN layer is laterally disposed at a low temperature below 1000°C, for example. This is because the vapor pressure of indium increases at a high temperature and indium is not effectively taken into the film. The low film formation temperature provides an effect of reducing the interaction between the mask portion 5 and the base semiconductor part 8. Another effect is that InGaN is less reactive to the mask portion 5 (for example, a silicon oxide film or a silicon nitride film) than GaN. When indium is taken into the base semiconductor part 8 at an In composition level of 1% or more, the reactivity with the mask portion 5 is further lowered. As the gallium raw material gas, triethylgallium (TEG) can be used.

### Example 4

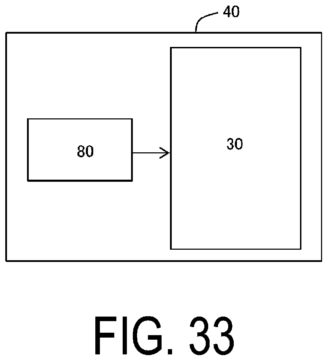

FIG. 33 is a schematic diagram illustrating a configuration of an electronic device according to Example 4. An electronic device 40 of FIG. 33 includes the semiconductor device 30 according to Examples 1 to 3, and a control unit 80 including a processor that controls the semiconductor device 30. Examples of the electronic device 40 include a communication device, an optical device, a display device, an illumination device, a sensor device, an information processing device, a medical device, and an electric vehicle (EV).

### Supplementary Note

In the present disclosure, the invention has been described above based on the various drawings and examples. However, the invention according to the present disclosure is not limited to each embodiment described above. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Main substrate
2 Buffer portion
3 Seed portion
4 Base portion
5 Mask portion
6 Mask pattern
8 Base semiconductor part
9 Compound semiconductor part
10 First light reflector
11 Second light reflector
15 Semiconductor substrate
20 Semiconductor laser element
30 Semiconductor device
K Opening portion
E1 First electrode
E2 Second electrode
H Hole
CB Circuit board
SK Support substrate

## Claims

1. A semiconductor device, comprising:
a semiconductor substrate comprising a main substrate, a base semiconductor part located above the main substrate, and a hole penetrating the main substrate in a thickness direction;
a compound semiconductor part located above the base semiconductor part;
a first light reflector located above the compound semiconductor part; and
a second light reflector disposed in the hole, overlapping the first light reflector, and below the first light reflector.

2. The semiconductor device according to claim 1, wherein
the base semiconductor part comprises a first portion, and a second portion overlapping the second light reflector in a thickness direction and having a threading dislocation density of one fifth or less of that of the first portion.

3. The semiconductor device according to claim 2, wherein
the second portion overlaps the first light reflector and the second light reflector in plan view.

4. The semiconductor device according to claim 3, further comprising:
an insulating film which is in contact with the upper surface of the compound semiconductor part, wherein
the insulating film comprises an aperture portion overlapping the first light reflector, the second portion, and the second light reflector in plan view.

5. The semiconductor device according to any one of claims 1 to 4, wherein
the first light reflector and/or the second light reflector is a reflecting mirror in which one or more low-refraction portions and one or more high-refraction portions are alternately stacked.

6. The semiconductor device according to any one of claims 1 to 5, further comprising: a first electrode located above the compound semiconductor part and overlapping the first light reflector in plan view.

7. The semiconductor device according to claim 6, further comprising:
a second electrode located above the base semiconductor part.

8. The semiconductor device according to any one of claims 1 to 7, further comprising:
a mask pattern located above the main substrate and comprising a mask portion and an opening portion, wherein
the base semiconductor part is disposed over the mask portion from the opening portion.

9. The semiconductor device according to claim 8, wherein
the semiconductor substrate comprises a base portion between the main substrate and the mask pattern.

10. The semiconductor device according to claim 9, wherein
the base portion comprises a seed portion overlapping the opening portion of the mask pattern in plan view.

11. The semiconductor device according to claim 9, wherein
at least a part of a bottom portion of the hole is in the base portion or the mask portion.

12. The semiconductor device according to claim 8, wherein
the hole penetrates the mask portion.

13. The semiconductor device according to any one of claims 1 to 12, wherein
the main substrate is a silicon substrate or a silicon carbide substrate.

14. The semiconductor device according to any one of claims 2 to 4, wherein
a threading dislocation density in the second portion is 5 x 10⁶/cm² or less.

15. The semiconductor device according to any one of claims 1 to 14, wherein
the compound semiconductor part comprises a first type semiconductor layer, an active layer, and a second type semiconductor layer in this order.

16. The semiconductor device according to any one of claims 1 to 15, further comprising:
one or more surface emitting semiconductor laser elements, each comprising the base semiconductor part, the compound semiconductor part, and the first and second light reflectors.

17. The semiconductor device according to claim 9, wherein
the base portion is provided locally to overlap the opening portion of the mask pattern.

18. The semiconductor device according to claim 17, wherein
the mask portion is a thermal oxide film of the main substrate.

19. The semiconductor device according to claim 3, wherein
the compound semiconductor part comprises
an aperture portion overlapping the first light reflector, the second portion, and the second light reflector in plan view, and
a high-resistance portion surrounding the aperture portion and having a current resistance higher than that of the aperture portion.

20. The semiconductor device according to claim 4 or 19, wherein
an area of a bottom surface of the hole is larger than an area of the aperture portion.

21. The semiconductor device according to any one of claims 1 to 20, wherein
the second light reflector is in contact with the bottom and a side wall of the hole.

22. The semiconductor device according to any one of claims 1 to 21, wherein
the second light reflector is in contact with a void portion in the hole.

23. The semiconductor device according to any one of claims 1 to 21, wherein
a phosphor is disposed in the hole, and
the second light reflector is located closer to the bottom side of the hole than the phosphor.

24. The semiconductor device according to any one of claims 1 to 23, wherein
the second light reflector is in contact with the lower surface of the main substrate.

25. The semiconductor device according to claim 7, wherein
the second electrode is in contact with the base semiconductor part.

26. The semiconductor device of claim 25, wherein
the second electrode has a recessed portion, and the recessed portion is filled with an insulating body.

27. The semiconductor device according to claim 7, further comprising:
a first pad in contact with the first electrode; and
a second pad in contact with the second electrode.

28. The semiconductor device of claim 27, wherein
upper surface levels of the first and second pads coincide with each other.

29. The semiconductor device according to claim 28, wherein
the upper surface levels of the first and second pads are higher than the upper surface level of the first light reflector.

30. The semiconductor device according to any one of claims 27 to 29, wherein
at least a part of the second pad overlaps none of the hole in plan view.

31. The semiconductor device according to any one of claims 27 to 30, wherein
at least a part of the first pad overlaps none of the hole in plan view.

32. The semiconductor device according to any one of claims 27 to 31, wherein
the first pad is in contact with the upper surface of the first light reflector.

33. The semiconductor device according to claim 4, further comprising:
a first electrode having translucency and located between the compound semiconductor part and the first light reflector.

34. The semiconductor device according to claim 33, wherein
the first electrode is in contact with the upper surface of the insulating film, and
the first electrode is in contact with the compound semiconductor part in the aperture portion.

35. The semiconductor device according to claim 33 or 34, wherein
the compound semiconductor part comprises a GaN-based semiconductor, and
the first electrode comprises gallium oxide.

36. The semiconductor device according to any one of claims 1 to 35, wherein
a reflectance of the second light reflector is smaller than a reflectance of the first light reflector.

37. The semiconductor device according to claim 5, wherein
the low-refraction portion and the high-refraction portion are each made of a dielectric material.

38. The semiconductor device according to claim 8, further comprising:
a first partition wall portion having light reflectivity and overlapping the opening portion of the mask pattern in plan view.

39. The semiconductor device according to claim 8, further comprising:
a second partition wall portion having light reflectivity and overlapping the center of the mask portion in plan view.

40. The semiconductor device according to any one of claims 1 to 39, wherein
the main substrate has a thermal conductivity larger than that of a GaN bulk substrate.

41. The semiconductor device according to claim 9, wherein
the base portion has a thermal conductivity larger than that of the base semiconductor part.

42. The semiconductor device according to claim 41, wherein
the base portion comprises silicon carbide.

43. The semiconductor device according to claim 8, wherein
the hole is tapered toward the mask pattern side.

44. The semiconductor device according to claim 7, wherein
the first electrode is an anode, and the second electrode is a cathode.

45. The semiconductor device according to claim 44, wherein
the first electrode and the second electrode are aligned in a <1-100> direction or a <11-20> direction of the base semiconductor part.

46. The semiconductor device according to claim 6, further comprising:
a circuit board electrically connected to the first electrode.

47. An electronic device comprising:
the semiconductor device according to any one of claims 1 to 46.

48. A method for manufacturing a semiconductor device, comprising:
forming a base semiconductor part on a template substrate by an ELO method, the template substrate comprising a main substrate and a mask pattern;
forming a compound semiconductor part above the base semiconductor part;
forming a first light reflector above the compound semiconductor part;
forming a hole penetrating the main substrate in the thickness direction and overlapping the first light reflector in plan view; and
forming a second light reflector in the hole.

49. An apparatus for manufacturing a semiconductor device configured to perform the method according to claim 48.

50. A semiconductor device, comprising:
a seed portion;
a mask pattern located above the seed portion and comprising a mask portion and an opening portion;
a base semiconductor part located above the mask pattern;
a compound semiconductor part located above the base semiconductor part;
a first light reflector located above the compound semiconductor part; and
a second light reflector located below the seed portion, overlapping the first light reflector, and below the first light reflector.

51. The semiconductor device according to claim 50, further comprising:
a support substrate located above the first light reflector.

52. A method for manufacturing a semiconductor device, comprising:
forming a base semiconductor part on a template substrate by an ELO method, the template substrate comprising a main substrate and a mask pattern;
forming a compound semiconductor part above the base semiconductor part;
forming a first light reflector above the compound semiconductor part;
removing the main substrate; and
forming a second light reflector on an opposite side to a side on which the first light reflector is located with reference to the mask pattern.

53. The method for manufacturing the semiconductor device according to claim 52, wherein
the template substrate, the base semiconductor part, and the compound semiconductor part are held by a support substrate before the main substrate is removed.
